# EUROPÄISCHE PATENTSCHRIFT

(11) **EP 2 486 610 B1**
(45) Veröffentlichungstag und Bekanntmachung des Hinweises auf die Patenterteilung: **12.07.2017**
(21) Anmeldenummer: 10799014.5
(22) Anmeldetag: 20.12.2010
(51) Int. Cl.: H01L 51/52

(54) **OPTOELEKTRONISCHE VORRICHTUNG MIT HOMOGENER LEUCHTDICHTE**
OPTOELECTRONIC DEVICE WITH HOMOGENEOUS LIGHT INTENSITY
DISPOSITIF OPTOÉLECTRONIQUE À LUMINANCE HOMOGÈNE

(30) Priorität: 21.12.2009 DE 102009055060
(43) Veröffentlichungstag der Anmeldung: 15.08.2012
(73) Patentinhaber: OSRAM OLED GmbH, 93049 Regensburg (DE)
(72) Erfinder: DIEKMANN, Carsten, 94371 Rattenberg (DE); KRISTUKAT, Christian, 93053 Regensburg (DE); KRUMMACHER, Benjamin, Claus, 93051 Regensburg (DE); ROSSBACH, Steven, 08626 Adorf (DE)
(74) Vertreter: Paul, Benjamin
(86) Internationale Anmeldenummer: PCT/EP2010/070249
(87) Internationale Veröffentlichungsnummer: WO 2011/085917

(56) Entgegenhaltungen:
- DE-A1-102005 002 836
- DE-A1-102008 023 035
- JP-A- 2005 285 523
- JP-A- 2006 252 866
- US-A- 2 755 457
- US-A1- 2007 075 636

## Beschreibung

Die vorliegende Erfindung betrifft eine optoelektronische Vorrichtung, beispielsweise eine organische lichtemittierende Diode oder eine elektrochrome Vorrichtung.

Eine organische lichtemittierende Diode (*organic light emitting diode* bzw. OLED) ist ein Lumineszenzstrahler, mit dem aus elektrischer Energie eine elektromagnetische Strahlung erzeugt wird. Die OLED weist zumindest eine organische aktive Schicht auf, in der die elektromagnetische Strahlung entsteht. Die aktive Schicht ist zwischen einer Anode und einer Kathode angeordnet. Bei einem angelegten Durchlasspotential injiziert die Anode Löcher in die aktive Schicht, während die Kathode Elektronen injiziert. Die injizierten Löcher und Elektronen wandern jeweils (unter dem Einfluss eines extern angelegten elektrischen Felds) zu der entgegengesetzt geladenen Elektrode und erzeugen bei Rekombination in der aktiven Schicht eine elektrolumineszente Emission.

Eine elektrochrome Vorrichtung hat typischerweise einen starren Träger für eine aktive Schicht, die ebenfalls zwischen einer Anode und einer Kathode eingebettet ist. Wenn eine Gleichspannung über die Anode und Kathode angelegt ist, entsteht in der aktiven Schicht eine Farbänderung. Für einige Anwendungen sind die Anode, Kathode und die aktive Schicht transparent. So kann die elektrochrome Schicht beispielsweise als Blendschutz in einer Windschutzscheibe oder einem Spiegel eines Kraftfahrzeugs eingesetzt werden.

Problematisch ist bei solchen elektrooptischen Vorrichtungen, dass aufgrund des intrinsischen Widerstands der Anode bzw. der Kathode eine laterale Spannung längs der jeweiligen Elektrode abfällt. Mit der lateralen Spannung wird der Verlauf der Spannung weg von einem Kontaktanschluss der Elektrode (Anode oder Kathode) bezeichnet. Dadurch entsteht bspw. bei einer OLED ein inhomogenes Leuchtbild. Bei einer elektrochromen Vorrichtung entsteht eine inhomogenes Farbbild. Beide Effekte sind unerwünscht und sollten möglichst unterdrückt werden. DE 10 2005 002 836 A1, US 2007/0075636 und DE 10 2008 023 035 A1 beschreiben optoelektronische Vorrichtungen, bei denen zur Leuchtdichtehomogenisierung in einer Schicht eine Widerstandsanpassung vorgenommen wird. Die US 2,755,457 beschreibt eine lumineszente Vorrichtung zur Anzeige der Empfangsstärke eines Radios. Die JP 2005 285523 A und die JP 2006 252866 A betreffen optoelektronische Vorrichtungen mit gezielt inhomogener Leuchtdichte.

Der vorliegenden Erfindung liegt das Problem zugrunde, eine optoelektronische Vorrichtung anzugeben, bei der eine möglichst homogene Spannung an der aktiven Schicht anliegt.

Dieses Problem wird durch eine optoelektronische Vorrichtung gemäß Patentanspruch 1 gelöst.

Weiterbildungen und vorteilhafte Ausgestaltungen der optoelektronischen Vorrichtung sind in den abhängigen Patentansprüchen angegeben.

### BEISPIELHAFTE AUSFÜHRUNGSFORMEN

Verschiedene Ausführungsformen der optoelektronischen Vorrichtung haben eine erste elektrische Zuleitung und eine zweite elektrische Zuleitung. Die zweite elektrische Zuleitung ist an einen ersten elektrischen Anschluss gekoppelt. Zwischen der ersten elektrische Zuleitung und der zweiten elektrische Zuleitung ist eine Funktionsschicht zur Emission von Strahlung angeordnet. Die zweite elektrische Zuleitung weist eine laterale erste elektrische Leitfähigkeit auf, die über eine Erstreckung der zweiten elektrische Zuleitung weg vom ersten elektrischen Anschluss monoton abnimmt. Die erste elektrische Zuleitung ist an einen zweiten elektrischen Anschluss gekoppelt. Die erste elektrische Zuleitung weist eine zweite elektrische Leitfähigkeit auf, die über eine Erstreckung der ersten elektrische Zuleitung weg von dem zweiten elektrischen Anschluss monoton abnimmt.

Die elektrischen Zuleitungen dienen der Zuführung und Injektion von Ladungsträgern in die Funktionsschicht. Sie haben häufig einen geeigneten Aufbau in Form einer Schichtabfolge, die Kontakte, Kontaktmaterialien, anorganische oder organische Ladungsträgertransportschichten etc. aufweisen. Sie können Metalle, bspw. Ag, bzw. Metallverbindungen umfassen. Dabei kann wenigstens eine der elektrischen Zuleitungen als transparente Zuleitung ausgestaltet sein. Die transparente Zuleitung kann ein transparentes, leitendes Oxid (*transparent conductive oxide* bzw. TCO) aufweisen. Das TCO ist der Regel ein Metalloxid, beispielsweise Zinkoxid, Zinnoxid, Cadmiumoxid, Titanoxid, Indiumoxid oder Indiumzinnoxid (ITO). Neben binären Metallstoffverbindungen, wozu auch SnO₂ und In₂O₃ zählen, gehören auch ternäre Metallsauerstoffverbindungen, wie beispielsweise Zn₂SnO₄, CdSnO₃, ZnSnO₃, MgIn₂O₄, GaInO₃, Zn₂In₂O₅ oder In₄Sn₃O₁₂ oder auch Mischungen unterschiedlicher transparenter leitender Oxide zu der Gruppe der TCO. Weiterhin entsprechen die TCO nicht zwingend einer stöchiometrischen Zusammensetzung und können auch p- oder n-dotiert sein, um eine hohe Leitfähigkeit zu erzielen. Die elektrischen Zuleitungen können hochleitende organische Materialien, wie Polyethylendioxythiophen ("PEDOT"), oder dotierte organische Schichten umfassen. In Zusammenhang mit organischen Leitungsschichten kann der Begriff "Dotierung" für eine partielle Oxidation bzw. Reduktion der organischen Schicht stehen. Es ist möglich, dass alle der genannten Materialien miteinander geeignet kombiniert in der ersten oder zweiten elektrischen Zuleitung vorhanden sind.

In einigen Ausführungsformen umfasst die Funktionsschicht eine organische Emitterschicht. Die optoelektronische Vorrichtung bildet somit ein organisches elektrolumineszierendes Bauelement, bzw. eine OLED.

In einigen Ausführungsformen umfasst die zweite elektrische Zuleitung eine Kontaktschicht. Dabei kann in einigen Ausführungsbeispielen die Kontaktschicht eine konstante elektrische Flächenleitfähigkeit aufweisen und sich eine Dicke der Kontaktschicht über die Ersteckung der Kontaktschicht weg vom ersten elektrischen Anschluss monoton verändern. Weil die Kontaktschicht in der Regel einen konstanten spezifischen Widerstand und damit einen konstanten Flächenwiderstand aufweist, ändert sich mit der Schichtdicke auch die jeweilige lokale Leitfähigkeit.

In einigen Ausführungsformen umfasst die zweite elektrische Zuleitung eine Ladungstransportschicht. Dabei kann die Ladungstransportschicht ein dotiertes organisches Halbleitermaterial umfassen. In einigen Ausführungsformen verändert sich eine Dotierkonzentration des dotierten organischen Halbleitermaterials weg von dem ersten elektrischen Anschluss monoton. Mit der Dotierung wird zugleich die Leitfähigkeit der Ladungstransportschicht eingestellt. Ein Leitfähigkeitsprofil in der zweiten elektrischen Zuleitung ist abhängig von einem Profil der Dotierkonzentration (Dotierprofil) in der Ladungstransportschicht.

In einigen Ausführungsformen verändert sich die erste elektrische Leitfähigkeit weg von dem ersten elektrischen Anschluss streng monoton, wobei die erste elektrische Leitfähigkeit weg von dem zweiten elektrischen Anschluss abnimmt .

In einigen Ausführungsformen bildet die zweite elektrische Zuleitung eine Kathode. Die erste elektrische Leitfähigkeit entspricht einer Elektronenleitfähigkeit.

Die erste elektrische Zuleitung kann eine Anode bilden. Die zweite elektrische Leitfähigkeit entspricht einer Lochleitfähigkeit.

### KURZE BESCHREIBUNG DER ZEICHNUNGEN

Verschiedene Ausführungsbeispiele einer optoelektronischen Vorrichtung werden im Folgenden anhand der Zeichnungen näher erläutert. In den Figuren geben die erste(n) Ziffer(n) eines Bezugszeichens die Figur an, in denen das Bezugzeichen zuerst verwendet wird. Die gleichen Bezugszeichen werden für gleichartige oder gleich wirkende Elemente bzw. Eigenschaften in allen Figuren verwendet.

Es zeigen:
- **Fig. 1**: ein Aufsicht auf eine optoelektronischen Vorrichtung;
- **Fig. 2**: einen Querschnitt durch eine erste bekannte Variante der optoelektronischen Vorrichtung nach **Fig. 1** längs einer Schnittachse A - A;
- **Fig. 3**: ein Ersatzschaltbild der optoelektronischen Vorrichtung;
- **Fig. 4**: einen Querschnitt durch eine zweite bekannte Variante der optoelektronischen Vorrichtung nach **Fig. 1** längs der Schnittachse A - A;
- **Fig. 5a**: eine erste Ausgestaltung der zweiten bekannten Variante nach **Fig. 4****;**
- **Fig. 5b**: ein erstes Verfahren zum Herstellen der ersten Kontaktschicht aus **Fig. 5a****,**
- **Fig. 5c**: ein zweites Verfahren zum Herstellen der ersten Kontaktschicht aus **Fig. 5a****,**
- **Fig. 6**: eine zweite Ausgestaltung der zweiten bekannten Variante nach **Fig. 4****;**
- **Fig. 7**: eine Simulation der Helligkeitsverteilung der bekannten optoelektronischen Vorrichtung nach **Fig. 2****;**
- **Fig. 8**: eine Simulation der Helligkeitsverteilung des ersten Ausführungsbeispiels der optoelektronischen Vorrichtung nach **Fig. 4****;**
- **Fig. 9**: einen Querschnitt durch eine erstes Ausführungsbeispiel der optoelektronischen Vorrichtung nach **Fig. 1** längs der Schnittachse A - A;
- **Fig. 10**: ein Aufsicht auf eine zweite optoelektronischen Vorrichtung, die bekannt ist;
- **Fig. 11**: einen Querschnitt durch die zweite optoelektronischen Vorrichtung nach **Fig. 10** längs einer Schnittachse A - A;
- **Fig. 12**: ein Aufsicht auf eine dritte optoelektronischen Vorrichtung, die bekannt ist und
- **Fig. 13**: einen Querschnitt durch die dritte optoelektronischen Vorrichtung nach **Fig. 12** längs einer Schnittachse A - A.

### DETAILLIERTE BESCHREIBUNG DER ZEICHNUNGEN

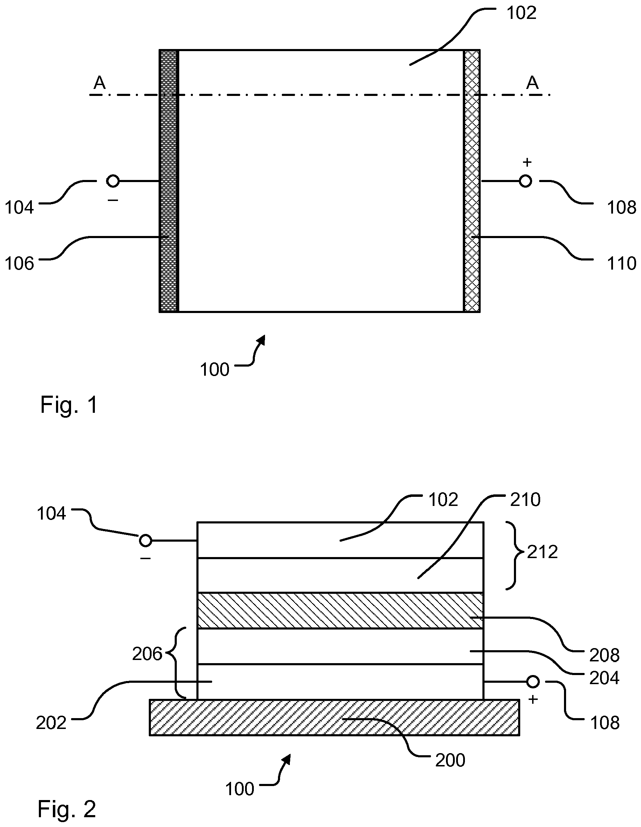

**Fig. 1** zeigt eine optoelektronischen Vorrichtung. Die optoelektronische Vorrichtung 100 ist beispielsweise eine elektrolumineszente Vorrichtung. Sie hat eine erste Oberseite auf der eine erste Kontaktschicht 102 aufgebracht ist. Die erste Kontaktschicht 102 ist mit einem ersten Anschluss 104 verbunden. Die Verbindung erfolgt über eine erste Elektrode 106, die Teil einer Kathode in dem gezeigten Ausführungsbeispiel der optoelektronischen Vorrichtung 100 ist. Eine Anode der optoelektronischen Vorrichtung 100 ist mit einem zweiten Anschluss 108 verbunden und weist eine zweite Elektrode 110 auf. Die zweite Elektrode 110 grenzt unmittelbar an eine zweite Kontaktschicht, welche die der ersten Kontaktschicht 102 gegenüberliegende Oberfläche der optoelektronischen Vorrichtung 100 bedeckt. Die zweite Kontaktschicht ist in **Fig. 1** nicht zu erkennen. Der Aufbau der optoelektronischen Vorrichtung 100 wird nachfolgend anhand von Querschnitten längs einer Schnittachse A - A genauer beschrieben. Dabei werden die sich gegenüberliegenden erste Elektrode 106 und zweite Elektrode 110 aus Gründen der vereinfachten Darstellung als Teil des ersten Anschlusses 104 bzw. des zweiten Anschlusses 108 betrachtet.

**Fig. 2** zeigt einen Querschnitt durch eine erste bekannte Variante der optoelektronischen Vorrichtung nach **Fig. 1** längs einer Schnittachse A - A. Die optoelektronische Vorrichtung 100 weist ein Substrat 200 auf, auf dem eine Schichtfolge aufgebracht ist. Typischerweise ist das Substrat 200 ein transparenter Träger, beispielsweise ein Glas oder eine Folie, wie beispielsweise eine biegsame Plastikfolie. Auf dem Substrat 200 ist eine zweite Kontaktschicht 202 aufgebracht. Auch die zweite Kontaktschicht 202 ist im Bereich der von der optoelektronischen Vorrichtung 100 emittierten Strahlung transparent. Dazu umfasst die erste Kontaktschicht 200 ein geeignetes transparentes leitfähiges Material, wie beispielsweise ein transparentes leitfähiges Oxid, etwa Indiumzinnoxid (ITO). Auf der zweiten Kontaktschicht 202 ist eine erste Ladungstransportschicht 204 aufgebracht. Die zweite Kontaktschicht 202 und die erste Ladungstransportschicht 204 bilden eine erste elektrische Zuleitung 206 der optoelektronischen Vorrichtung 100. Die erste elektrische Zuleitung 206 ist eine Anode der optoelektronischen Vorrichtung 100. Entsprechend umfasst die erste Ladungstransportschicht 204 ein Material mit einer hohen Mobilität von Löchern.

Auf der ersten elektrischen Zuleitung 206 ist eine Funktionsschicht 208 aufgebracht, in der eine emittierte Strahlung erzeugt wird, sobald an diese eine elektrische Spannung angelegt ist. Die Funktionsschicht 208 weist ein elektrolumineszentes Material auf. Beispielsweise kann das elektrolumineszente Material geeignete Polymere für eine Fluoreszenz- oder eine Phosphoreszenzemission aufweisen. Alternativ können kleine organische Moleküle, die über Fluoreszenz oder über Phosphoreszenz emittieren, als organische Elektrolumineszenzschicht dienen.

Auf der Funktionsschicht 208 ist eine zweite Ladungstransportschicht 210 aufgebracht, auf der wiederum eine erste Kontaktschicht 102 aufgebracht ist. Die zweite Ladungstransportschicht 210 und die erste Kontaktschicht 102 bilden eine zweite elektrische Zuleitung 212 der strahlungsemittierenden Vorrichtung 100. In dem gezeigten Ausführungsbeispiel ist die zweite elektrische Zuleitung 206 eine Kathode der strahlungsemittierenden Vorrichtung 100.

Die erste elektrische Zuleitung 206 ist mit einem zweiten Anschluss 108 verbunden. Die zweite elektrische Zuleitung 212 ist mit einem ersten Anschluss 104 verbunden. Der erste Anschluss 104 und der zweite Anschluss 108 dienen zur Stromzufuhr an die optoelektronische Vorrichtung 100. Dazu können der erste Anschluss 104 und der zweite Anschluss 108 an eine Energiequelle gekoppelt werden. Beispielsweise sind sie an eine konstante Stromquelle, bspw. eine Batterie oder eine Treiberschaltung, gekoppelt.

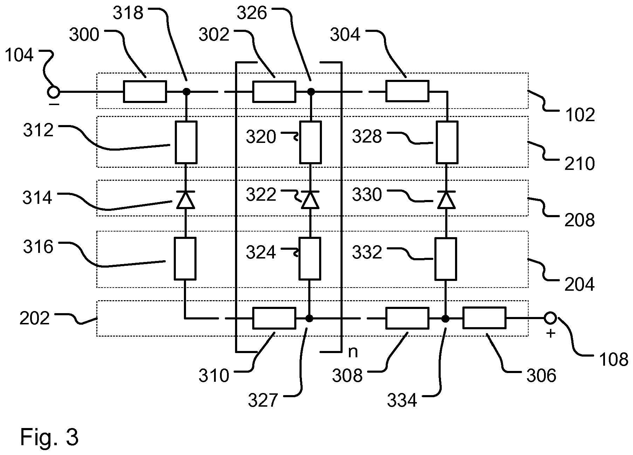

**Fig. 3** zeigt ein Ersatzschaltbild der optoelektronischen Vorrichtung 100. Die erste Kontaktschicht 102 weist dabei im wesentlichen eine hohe laterale und vertikale Leitfähigkeit auf. Sie ist an den ersten Anschluss 104 gekoppelt. Der intrinsische Widerstand der ersten Kontaktschicht 102 wird in der lateralen Erstreckung als Reihenschaltung eines ersten Widerstands 300, eines zweiten Widerstands 302 und eines dritten Widerstands 304 beschrieben. Üblicherweise wird die erste Kontaktschicht 102 ein Metall, wie bspw. Al, aufweisen. Ebenso kann sie ein transparentes leitfähiges Oxid (*Transparent Conductive Oxide,* bzw. TCO), wie beispielsweise Indiumzinnoxid (*Indium Tin Oxide,* bzw. ITO), aufweisen. Der erste Widerstand 300, der zweite Widerstand 302 und der dritte Widerstand 304 werden als ohmsche Widerstände modelliert.

Das gleiche gilt für die zweite Kontaktschicht 202, die an den zweiten Anschluss 108 gekoppelt ist. Die elektrische Leitfähigkeit der zweiten Kontaktschicht 202 wird durch eine Reihenschaltung eines vierten Widerstands 306, eines fünften Widerstands 308 und eines sechsten Widerstand 310.

Zwischen der ersten Kontaktschicht 102 und der zweiten Kontaktschicht 202 verlaufen die elektrischen Ströme in der optoelektronischen Vorrichtung im wesentlichen in vertikaler Richtung. Sie durchlaufen dabei die erste Ladungstransportschicht 204, die Funktionsschicht 208 und die zweite Ladungstransportschicht 210. Die erste Ladungstransportschicht 204 wird auch als *electron transport layer* (ETL) bezeichnet. Sie kann beispielsweise ein n-dotiertes leitfähiges organisches oder anorganisches Material aufweisen. Die zweite Ladungstransportschicht 204 wird auch als *hole transport layer* (HTL) bezeichnet. Sie kann beispielsweise ein p-dotiertes leitfähiges organisches oder anorganisches Material aufweisen. Für beide Ladungstransportschichten können auch geeignete intrinsische, d.h. undotierte Schichten verwendet werden. In aller Regel weisen beide Ladungstransportschichten einen ohmschen vertikalen Widerstand auf.

Die Funktionsschicht 208 weist ein nicht-ohmsches Verhalten auf. Das bedeutet, dass zwischen einer an der Funktionsschicht 208 angelegten Spannung (V) und einem durch die Funktionsschicht fließenden Strom (I) kein linearer Zusammenhang besteht. Weist die Funktionsschicht beispielsweise einen pn-Übergang auf, so entspricht ihr Verhalten einer Diode, log(I) α V.

Bei einer organischen Lumineszenzdiode weist die Funktionsschicht 208 beispielsweise ein organisches Elektrolumineszenzmaterial auf, das bei Anlegen eines Potentials Licht emittiert. Das organische Elektrolumineszenzmaterial ist beispielsweise ein Polymer. Es können auch kleine organische Moleküle, die über Fluoreszenz oder über Phosphoreszenz emittieren, als organisches Elektrolumineszenzmaterial dienen. In diesem Fall erfolgt ein Ladungsträgertransport über Hüpf- oder Tunnelprozesse. Der Zusammenhang zwischen angelegter Spannung (V) und durch die Funktionsschicht 208 fließendem Strom I lässt sich entsprechend der I-V- Charakteristik einer Elektronenröhre beschreiben, d.h. I α V^{2/3}.

Entsprechend dieser Eigenschaften der verschiedenen Schichtebenen der optoelektronischen Vorrichtung kann die optoelektronische Vorrichtung in vertikaler Richtung durch eine Reihenschaltung aus einem ohmschen Widerstand, einem nichtlinearen Element, wie einer Diode, und einem weiteren ohmschen Widerstand dargestellt werden. Wegen der lateralen Ersteckung der optoelektronischen Vorrichtung kann der Strom in vertikaler Richtung durch eine Parallelschaltung mehrerer solcher Reihenschaltung modelliert werden.

Entsprechend ist in der **Fig. 3** ein erste Strompfad dargestellt, der eine Reihenschaltung eines siebten Widerstands 312, einer ersten Diode 314 und eines achten Widerstands 316 aufweist. Der erste Strompfad verbindet einen zwischen den dem ersten Widerstand 300 und den zweiten Widerstand 302 liegenden Knoten 318 mit dem sechsten Widerstand 310. Dazu parallel geschaltet befindet sich ein zweiter Stromzweig, der eine Reihenschaltung aus einem neunten Widerstand 320, einer zweiten Diode 322 und eines zehnten Widerstands 324 umfasst. Der zweite Strompfad verbindet einen zwischen dem zweiten Widerstand 302 und dem dritten Widerstand 304 befindlichen zweiten Knoten 326 mit einem zwischen dem sechsten Widerstand 310 und dem fünften Widerstand 308 befindlichen dritten Knoten 327. Die Parallelschaltung wird durch einen dritten Stromzweig abgeschlossen, die eine Reihenschaltung aus einem elften Widerstand 328, einer dritten Diode 330 und einem zwölften Widerstand 332 umfasst. Der dritte Stromzweig verbindet den dritten Widerstand 304 mit einem zwischen dem fünften Widerstand 308 und dem vierten Widerstand 306 befindlichen Knoten 334.

In der **Fig. 3** ist angedeutet, dass das Ersatzschaltbild durch ein mehrfaches (n-faches) Wiederholen des zweiten Strompfads verbessert werden kann. Im Grenzwert wird so ein Stromdichten-Modell mit spezifischen Leitfähigkeiten wiedergegeben.

In der in **Fig. 2** gezeigten bekannten optoelektronischen Vorrichtung weisen alle leitfähigen Schichten über die laterale Ersteckung eine konstante Leitfähigkeit auf. Entsprechend sind die Widerstandswerte des ersten Widerstands 300, des zweiten Widerstands 302 und des dritten Widerstands 304 identisch. Ebenso sind die Widerstandswerte des vierten Widerstands 306, des fünften Widerstands 308 und des sechsten Widerstands 310 identisch.

Die Materialien der ersten Kontaktschicht 102 und der zweiten Kontaktschicht 202 sind im Falle einer transparenten optoelektronische Vorrichtung häufig identisch, so dass sich die spezifische Leitfähigkeit nicht unterscheidet. In einer Vielzahl anderer Anwendungen unterscheiden sich jedoch die Materialien. In diesem Fall sind die spezifischen Leitfähigkeiten und damit auch in aller Regel der Widerstandswert des ersten Widerstands 300, bzw. des zweiten Widerstands 302 und des dritten Widerstands 304 verschieden von dem Widerstandswert des vierten Widerstands 306, bzw. des fünften Widerstands 308 und des sechsten Widerstands.

Die erste Ladungstransportschicht 210 und die zweite Ladungstransportschicht 204 weisen in der Regel unterschiedliche Dotierungen und damit auch zueinander unterschiedliche Leitfähigkeiten auf. Dabei kann berücksichtigt werden, dass üblicherweise Materialien zur Verfügung verwendet werden, bei denen eine Lochtransportschicht eine erheblich höhere Löchermobilität aufweist, als die Elektronenmobilität der verwendeten Elektronentransportschichten. In jeder Schicht ist die jeweilige Leitfähigkeit jedoch im Fall der bekannten optoelektronischen Vorrichtung aus **Fig.2** in der lateralen Ersteckung konstant, so dass der siebte Widerstand 312, der neunte Widerstand 320 und der elfte Widerstand 328 einen gleichen Widerstandswert aufweisen. Ebenso weisen der achte Widerstand 316, der zehnte Widerstand 324 und der zwölfte Widerstand 332 einen gleichen Widerstandswert auf. Die Funktionsschicht 208 weist ebenfalls eine homogene elektrische Leitfähigkeit auf, so dass die Kennlinien der ersten Diode 314, der zweiten Diode 322 und der dritten Diode 330 identisch sind.

Damit hat die in der **Fig. 2** gezeigte optoelektronische Vorrichtung eine homogene Struktur hinsichtlich ihrer elektrischen Eigenschaften. Infolgedessen entsteht bei einem konstanten Strom, der über den ersten Anschluss 104 und zweiten Anschluss 108 eingeprägt ist, ein Spannungsabfall entlang der lateralen Ausdehnung der optoelektronischen Vorrichtung. Dieser Effekt wird beispielsweise in dem Dokument [1] beschrieben. Damit entsteht beispielsweise bei einer OLED ein uneinheitliches, d.h. inhomogenes Leuchtbild.

Im Folgenden wird anhand einzelner Ausführungsbeispiele gezeigt, wie ein möglichst homogenes Leuchtbild erreicht wird. Dabei zielen alle nachfolgend dargestellten Ausführungsbeispiele darauf ab, eine möglichst homogene vertikale Spannungsverteilung an der Funktionsschicht 208 zu erzielen.

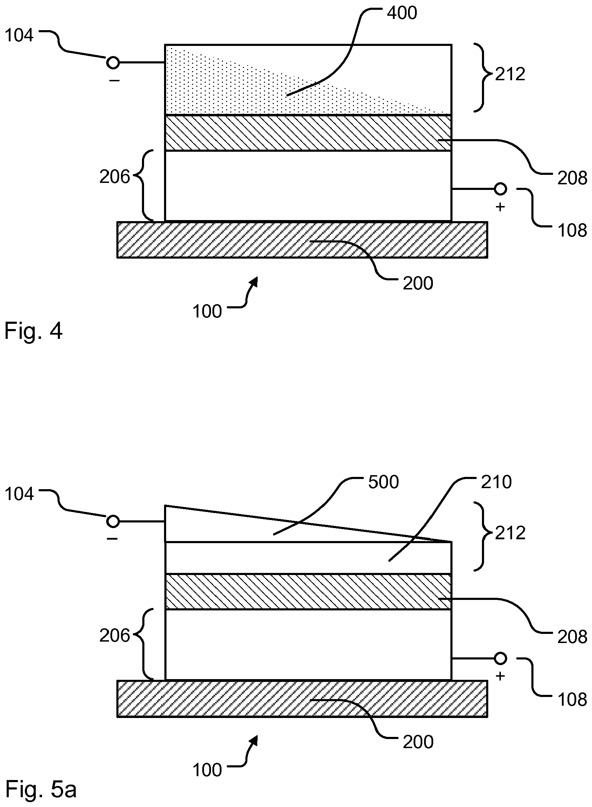

**Fig. 4** zeigt einen Querschnitt durch eine zweite bekannte Variante der optoelektronischen Vorrichtung 100 nach **Fig. 1** längs der Schnittachse A - A. Das erste Ausführungsbeispiel unterscheidet sich von der bekannten Vorrichtung der **Fig. 2** dadurch, dass die zweite elektrische Zuleitung 212 von dem ersten Anschluss 104 weg einen Verlauf der Leitfähigkeit 400 aufweist. Dabei nimmt die Leitfähigkeit 400 in Abstand von dem ersten Anschluss weg ab. Bevorzugterweise kann mit einer linear abfallenden Leitfähigkeit eine besonders homogene Leuchtdichte erzielt werden.

Dies kann beispielsweise dadurch geschehen, dass in der ersten Kontaktschicht ein Verlauf der lateralen Leitfähigkeiten vorgesehen ist. Im Sinne des Ersatzschaltbildes der **Fig. 3** ist beispielsweise ein Widerstandswert R₁ des ersten Widerstands 300 kleiner als ein Widerstandswert R₂ des zweiten Widerstands 302, wobei R₂ wiederum kleiner ist als ein Widerstandswert R₃ des dritten Widerstands 304. Damit weist die Leitfähigkeit einen streng monoton fallenden Verlauf 400 weg von dem ersten Anschluss 104 auf. Dies kann beispielsweise durch eine geeignete Wahl der Schichtdicke der ersten Kontaktschicht auf. Eine solches Ausführungsbeispiel ist in **Fig. 5a** dargestellt. Hier ist im wesentlichen die Struktur der **Fig. 2** jedoch mit einer erste Kontaktschicht 500 dargestellt, deren Schichtdicke D von dem ersten Anschluss 104 weg abnimmt. Da die erste Kontaktschicht 500 aus einem homogenen Material besteht, das eine konstante spezifische Leitfähigkeit ρ aufweist, nimmt der Schichtwiderstand R_{sq} = ρ/D vom ersten Anschluss 104 weg zu. Ein solches Schichtdickeprofil kann durch eine Vielzahl von Verfahren erzeugt werden. So kann die erste Kontaktschicht 500 unter Verwendung einer Vielzahl von Masken erzeugt werden. Damit würde ein treppenförmiger Verlauf der Schichtdicke erzeugt werden können. Auch kann die erste Kontaktschicht 500 durch einen Beschichtungsprozess, bspw. einem Aufdampfen, erzeugt werden. Dabei können mittels eines schrägen oder einen unterschiedlich starken Aufdampfen unterschiedliche Schichtdickenprofile erzeugt werden. Ebenso ist es denkbar, dass die erste Kontaktschicht 500 in einem Druckverfahren, beispielsweise einem Siebdruck mit geeigneten Druckmasken erzeugt wird. Ebenso kann bei einem Drucken mit organischen Materialien mittels definierter Temperaturprofile beim Ausheizen der gedruckten Schicht das Schichtdickenprofil geeignet gewählt werden.

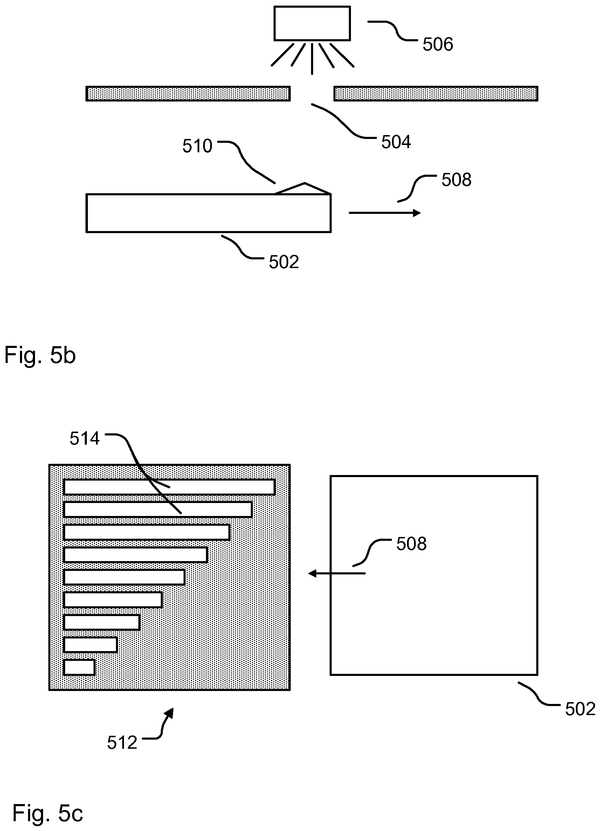

In der **Fig. 5b** und der **Fig. 5c** sind beispielhaft zwei Verfahren zum Aufbringen der ersten Kontaktschicht 500 dargestellt. Die **Fig. 5b** zeigt ein erstes Verfahren einer ersten Kontaktschicht 500 auf einen Schichtstapel 502. Dazu wird der Schichtstapel 502 unter einer Blende 504 geführt. Die Blende 504 erstreckt sich schlitzförmig in die Tiefe der Darstellung der **Fig. 5b****,** wobei der Schichtstapel 502 und die Blende 504 in einem Querschnitt dargestellt sind. Die Blende 504 weist in der Erstreckung in die Tiefe in etwas die Länge der Tiefe des Schichtstapels 502 auf. Die Blende 504 ist zwischen einer Materialquelle 506 und dem Schichtstapel 502 angeordnet. Aus der Materialquelle 506 wird Material zum Herstellen der ersten Kontaktschicht, bspw. über Verdampfen, emittiert und tritt durch die Blende 504 auf einer Oberfläche des Schichtstapels 502. Der Schichtstapel 502 wird unter der Blende entlang geführt, wobei er parallel zu Blende 502 in horizontaler Richtung 508 bewegt wird. Dabei wird das aus der Materialquelle 506 emittierte Material auf den unterhalb der Blende 502 befindlichen Abschnitt der Oberfläche abgelagert und bildet so einen Abschnitt 510. Die lokale Dicke eines Bereichs des Abschnitts 510 wird dabei durch die Zeit bestimmt, die der Bereich der Materialquelle 506 ausgesetzt ist. Wird diese Zeit variiert, können unterschiedliche Dicken erreicht werden. Um einen lateral stetigen Verlauf der Dicke der ersten Kontaktschicht 500 zu erzielen, wird der Schichtstapel mit einer beschleunigten (d.h. im schnelleren oder immer langsameren) Bewegung an der Blende 504 vorbeigeführt. Wird die Bewegung abgebremst, so nimmt die Dicke der ersten Kontaktschicht in Bereichen zu, die zuletzt der Materialquelle 506 ausgesetzt werden, so wie es in der **Fig. 5b** angedeutet ist. Wird die Bewegung schneller, so entstehen in den zunächst bedampften Bereichen ein dickeres Profil der ersten Kontaktschicht 500, das hin zu später bedampften Bereichen in der Dicke abnimmt.

Ein zweite Verfahren zum Aufbringen der ersten Kontaktschicht 500 wird an Hand der **Fig. 5c** deutlich. Dabei ist eine Aufsicht auf ein Blendensystem gezeigt. Das Blendensystem weist eine Blendenplatte 512 auf. Die Blendenplatte 512 weist eine Vielzahl von Blendenschlitzen 514 auf. Die Blendenschlitze 514 sind jeweils unterschiedlich lang. Durch die Blendenschlitze 514 kann ein aus einer (in der **Fig. 5c** aus Gründen der Übersichtlichkeit nicht dargestellte) Materialquelle austretendes Material durch das Blendenssystem 512 treten. Unter dem Blendensystem 512 wird der Schichtstapel 502 mit konstanter Geschwindigkeit geführt. Dabei tritt durch die durch Blendenschlitze 514 eine jeweils von der Länge eines Blendenschlitzes abhängige Menge des Materials auf die Oberfläche des Schichtstapels 502 und bildet so eine Kontaktschicht 500, die in Richtung einer Längserstreckung ein stetig variierendes Dickenprofil aufweist.

Bei der Umsetzung des zweiten Verfahrens wird eine Materialquelle bereitgestellt, die einen homogenen Materialstrom über die gesamte Fläche des Blendensystems 512 bereitstellt. Ebenso ist es denkbar, über oder anstelle des Blendensystems 512 ein System kleinerer Materialquellen bereitzustellen. Dabei wird über eine oder anstelle längerer Blendenschlitze eine höhere Anzahl an kleinerer Materialquellen und über oder anstelle kürzerer Blendenschlitze eine geringere Anzahl von Materialquellen angeordnet sein.

Hinsichtlich aller Verfahren ist eine Relativbewegung zwischen der Materialquelle bzw. dem Blendesystem oder der Blende und dem Schichtstapel nötig. Es versteht sich, dass es hinreichend ist, eine der Komponenten zu bewegen, um ein vertikales Schichtdickenprofil zu erhalten.

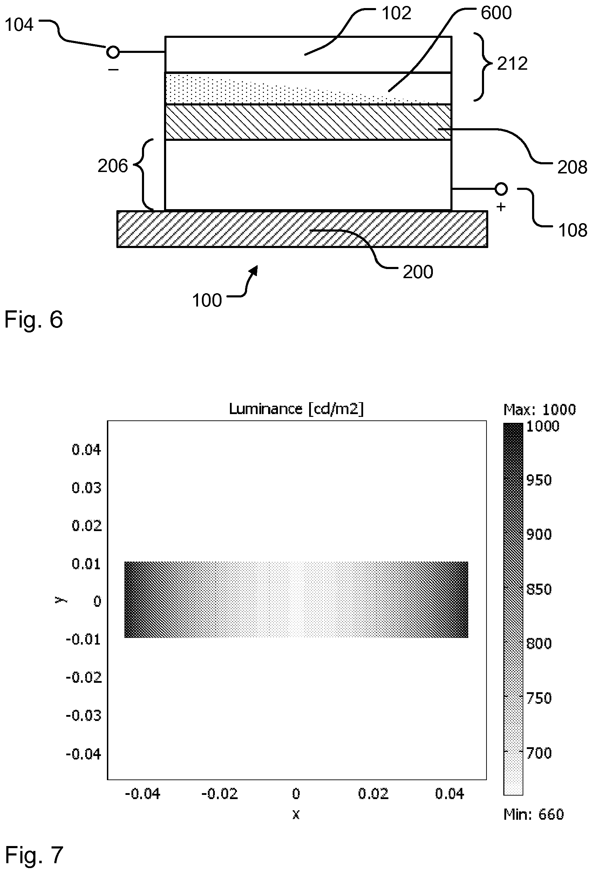

Zusätzlich oder alternativ zu dem in **Fig. 5a** dargestelltem Beispiel kann die horizontale Leitfähigkeit der zweiten elektrischen Zuleitung 212 von dem ersten Anschluss 104 weg monoton abnehmen. Im wesentlichen trägt die Leitfähigkeit der zweiten Ladungstransportschicht dazu bei. Bei der zweiten Ladungstransportschicht handelt es sich beispielsweise um ein n-dotiertes Material. Die Leitfähigkeit kann, wie in **Fig. 6** im Unterschied zur Struktur der **Fig. 2** dargestellt, in ihrem lateralen Verlauf dadurch beeinflusst werden, dass eine zweite Ladungstransportschicht 600 vorgesehen ist, die ein vom ersten Anschluss weg verlaufendes Dotierungsprofil aufweist, wobei die Konzentration an Dotierstoffen weg vom ersten Anschluss 104 kontinuierlich abnimmt. Im Ersatzschaltbild der **Fig. 3** ist also ein Widerstandwert R₇ des siebten Widerstands 312 kleiner als ein Widerstandswert R₉ des neunten Widerstands 320, wobei R₉ kleiner ist als ein Widerstandswert R₁₁ des elften Widerstands 328. Dabei kann beim Herstellen der Ladungstransportschicht die lokale Dotierkonzentration durch eine Vielzahl von Verfahren eingestellt werden. So werden in aller Regel größere Zwischenprodukte einen Teilchenstrom aus einer Dotierquelle ausgesetzt. Durch die Geschwindigkeit, mit der das Zwischenprodukt den Wirkungsquerschnitt durchläuft oder durch eine Veränderung der Temperatur der Dotierquelle wird die Gesamtdosis und damit auch die aufgenommenen Dotierkonzentration im Zwischenprodukt beeinflusst. Ebenso wären bei kleineren Werkstücken Abschirmungen und kleinere Filtermasken denkbar, um die Dotierdosis zu beeinflussen.

Die in den **Fig. 5a** und **Fig. 6** gezeigten Maßnahmen können geeignet kombiniert werden. Insgesamt wird die an der Funktionsschicht 208 anliegende Spannung durch die über den ersten Anschluss 104 und den zweiten Anschluss 108 zugeführten Ladungsträger bestimmt. Durch die hohen Leitfähigkeiten der zweiten elektrischen Zuleitung 212 in Nähe des ersten Anschlusses 104 kann zwar ein großer Elektronenstrom getrieben werden, der tatsächliche Strom bleibt aber durch den Zufluss an Löchern auf Seite der Anode begrenzt. Hingegen ist der Elektronenstrom in Nähe des Anodenanschlusses, also des zweiten Anschlusses 108 durch die geringere Leitfähigkeit begrenzt. Die Leuchtdichte in Nähe des ersten Anschlusses 104 und in Nähe des zweiten Anschlusses 108 wird durch den begrenzten Ladungsträgerstrom verringert. Insgesamt erscheint damit das Leuchtbild homogener.

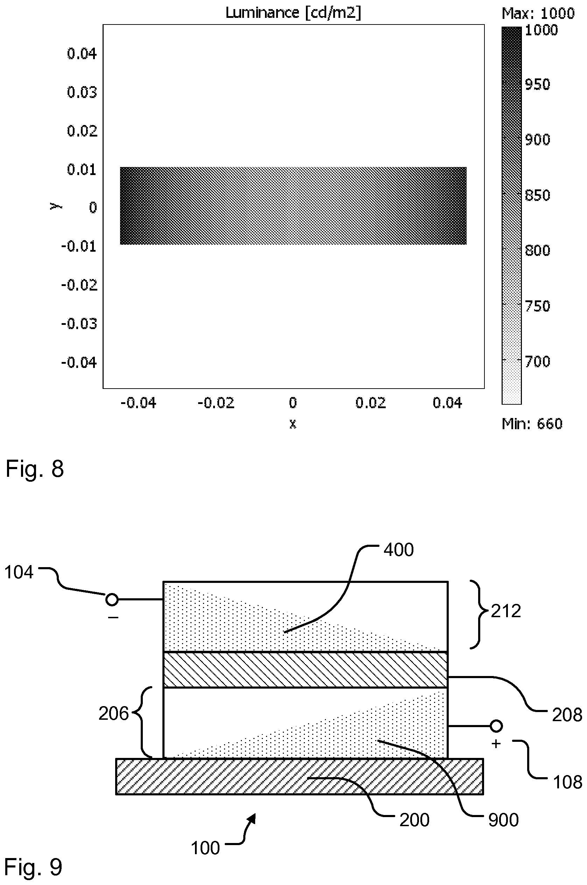

Anhand der **Fig. 7** und der **Fig. 8** wird deutlich, dass durch die beschriebene Maßnahme ein homogenes Leuchtbild erzielt wird. **Fig. 7** zeigt eine Simulation der Helligkeitsverteilung der bekannten optoelektronischen Vorrichtung nach **Fig. 2****.** Dabei ist in Form von Graustufen die Leuchtdichtenverteilung in cd/m² auf einer Oberfläche einer elektrolumineszenten Vorrichtung dargestellt. Die Abszisse (X-Achse) gibt dabei die Erstreckung zwischen einem Kathodenanschluss auf der linken Seite und einem Anodenanschluss auf der rechten Seite wieder. Die Ordinate (Y-Achse) gibt eine Ersteckung längs der Anschlüsse wieder (vgl. mit der Darstellung in **Fig. 1**). Die Simulation lässt erkennen, dass die Leuchtdichte in Mitte zwischen den Anschlüssen deutlich geringer ist, als in Nähe eines der Anschlüsse. Die Skalen der Ausdehnung und der Leuchtdichte sind für die Simulation gewählt und sind daher nur als beispielhaft zu verstehen.

Als Vergleich dazu zeigt die **Fig. 8** eine Simulation der Helligkeitsverteilung der optoelektronischen Vorrichtung nach **Fig. 4****.** Es wurde eine zu der **Fig. 7** vergleichbare Darstellung gewählt. Im Vergleich ist zu erkennen, dass die Leuchtdichte für die bekannte optoelektronischen Vorrichtung nach **Fig. 4** erheblich homogener erscheint als die Leuchtdichte der bekannten optoelektronischen Vorrichtung nach **Fig. 2****.**

**Fig. 9** zeigt einen Querschnitt durch ein erstes Ausführungsbeispiel einer optoelektronischen Vorrichtung 100 nach **Fig. 1** längs der Schnittachse A - A. Das erste Ausführungsbeispiel unterscheidet sich von der zweiten bekannten Variante dadurch, dass die erste elektrische Zuleitung 206 von dem zweiten Anschluss 108 weg einen Verlauf der Leitfähigkeit 900 aufweist. Dabei nimmt die Leitfähigkeit 900 in Abstand von dem ersten Anschluss weg ab. Soweit es sich bei dem zweiten Anschluss 108 um eine Anode handelt, ist mit der Leitfähigkeit eine Lochleitfähigkeit gemeint. Die Leitfähigkeit kann analog zu der Leitfähigkeit der zweiten elektrischen Zuleitung 212 durch eine Veränderung der Dicke der zweiten Kontaktschicht und/oder durch eine Wahl der Dotierkonzentration in der ersten Ladungstransportschicht lokal eingestellt werden.

Es wird also zusätzlich ein Leitfähigkeitsprofil in der Anode vorgesehen. Insgesamt kann damit der Zustrom von Ladungsträgern auf beiden Kontaktseiten der Funktionsschicht 208 gesteuert werden. Da die Lochleitfähigkeit in aller Regel höher ausfallen wird, als die Elektronenleitfähigkeit, ist diese Maßnahme insbesondere zusätzlich zu einer Anpassung der Elektronenleitfähigkeit vorteilhaft.

### OPTOELEKTRONISCHE VORRICHTUNG MIT VERSETZTEN ELEKTRODEN

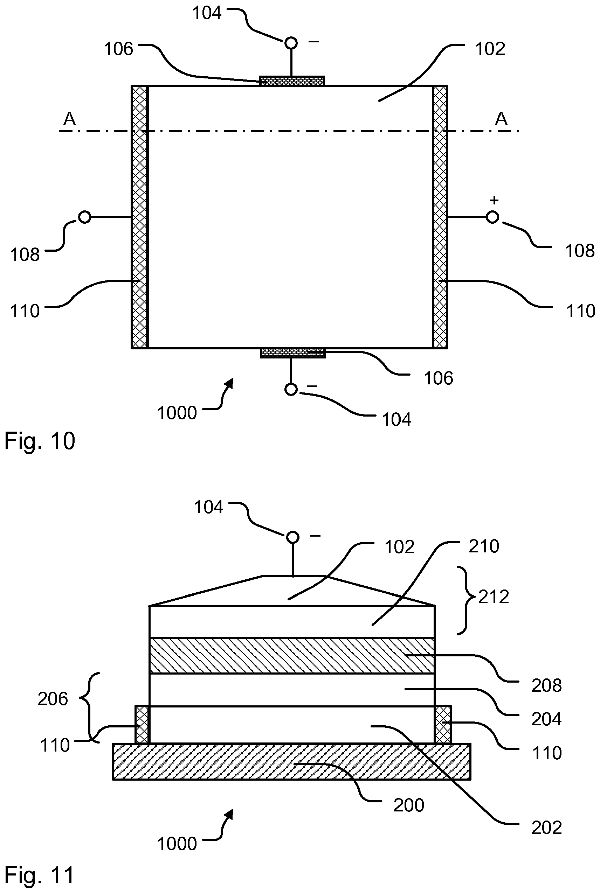

**Fig. 10** zeigt eine Aufsicht auf eine zweite optoelektronische Vorrichtung 1000. Aus der Aufsicht wird deutlich, dass sich die zweite optoelektronische Vorrichtung 1000 von der ersten optoelektronischen Vorrichtung dadurch unterscheidet, dass die zweite Elektrode 110 mit jeweils einem Teilbereich an zwei gegenüberliegenden Seitenkanten der zweiten optoelektronischen Vorrichtung 1000 angeordnet ist. Die erste Elektrode 106 ist mit jeweils einem Teilbereich an Teilstücken der beiden anderen, sich ebenfalls gegenüberliegenden Seitenkanten angeordnet. Damit entsteht ein im Vergleich zu der ersten optoelektronischen Vorrichtung unterschiedliches Stromdichtenprofil durch den Körper der optoelektronischen Vorrichtung.

Der Aufbau der zweiten optoelektronischen Vorrichtung 1000 wird anhand der **Fig. 11** deutlicher. **Fig. 11** zeigt einen Querschnitt durch ein Beispiel der zweiten optoelektronischen Vorrichtung 1000 längs der Schnittachse
A - A. Auf einem Substrat 200 ist eine erste elektrische Zuleitung 206 aufgebracht. Sie weist, wie im Fall der ersten optoelektronischen Vorrichtung, eine zweite Kontaktschicht 202 und eine erste Ladungstransportschicht 204 auf. Diese Schichten weisen jeweils Materialien auf, wie sie im Zusammenhang mit der ersten optoelektronischen Vorrichtung beschrieben sind. Die zweite Kontaktschicht 202 ist elektrisch mit der zweiten Elektrode 110 verbunden, die sie von zwei Seiten her kontaktiert.

Auf der ersten elektrischen Zuleitung 206 ist wie bei der ersten optoelektronischen Vorrichtung eine Funktionsschicht 208 aufgebracht, die ihrerseits von einer zweiten elektrischen Zuleitung 212 bedeckt ist. Die zweite elektrische Zuleitung 212 besteht aus einer zweiten Ladungstransportschicht 210 und einer ersten Kontaktschicht 102. Die erste Kontaktschicht 102 ist mit der ersten Elektrode 106 kontaktiert, wie in Zusammenschau mit der Darstellung der **Fig. 10** deutlich wird. Sie weist in der Achse zwischen den beiden Teilstücken der ersten Elektrode eine konstante Dicke und damit eine konstante Leitfähigkeit auf, die von diesen Bereich hin zu den Seitenkanten kontinuierlich abnimmt. Es wäre ebenso denkbar, dass die erste Kontaktschicht 102 eine homogene Schichtdicke aufweist und stattdessen beispielsweise die zweite Ladungsträgerschicht 210 ein entsprechendes Dotierprofil aufweist. Die Wahl des Dotierprofils wird in Zusammenschau mit dem Ausführungsbeispiel der **Fig. 6** deutlich. Wichtig ist, dass die Leitfähigkeit der zweiten elektrischen Zuleitung zu den Bereichen hin abnimmt, die geometrisch näher an der zweiten Elektrode 110 liegen.

Es ist ein Grundgedanke, dass abhängig von der Anordnung und der Geometrie der ersten Elektrode 106 und der zweiten Elektrode 110 die zweite elektrische Zuleitung 212 (und in analoger Weise auch die zweite Zuleitung 206) derart gestaltet werden, dass die Ladungsträger-Leitfähigkeit der jeweiligen elektrischen Zuleitung von der entsprechenden Elektrode weg hin zu der Elektrode mit entgegengesetzt ausgerichteter Polarität abnimmt.

### OPTOELEKTRONISCHE VORRICHTUNG MIT RINGELEKTRODE

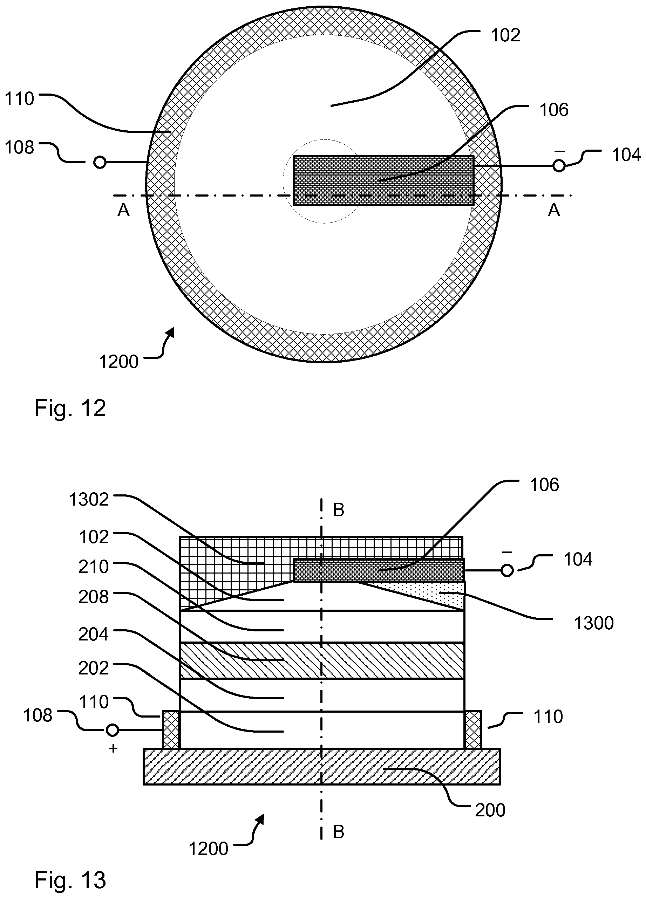

Eine weitere optoelektronische Vorrichtung mit einer anderen Elektrodenstruktur wird anhand einer dritten optoelektronischen Vorrichtung beschrieben. Dabei zeigt **Fig. 12** eine Aufsicht auf die dritte optoelektronische Vorrichtung 1200. Zur Verdeutlichung der Darstellung wurde eine auf dieser Seite üblicherweise aufgebrachte Verkapselung nicht dargestellt.

Die optoelektronische Vorrichtung 1200 ist eine elektrolumineszente Vorrichtung. Sie hat eine erste Oberseite auf der eine erste Kontaktschicht 102 aufgebracht ist. Die erste Kontaktschicht 102 ist mit einem ersten Anschluss 104 verbunden. Die Verbindung erfolgt über eine erste Elektrode 106, die Teil einer Kathode in dem gezeigten Ausführungsbeispiel der optoelektronischen Vorrichtung 1200 ist. Die erste Elektrode 106 ist auf der ersten Kontaktschicht 102 aufgebracht. Eine Anode der optoelektronischen Vorrichtung 1200 ist mit einem zweiten Anschluss 108 verbunden und weist eine zweite Elektrode 110 auf. Die zweite Elektrode 110 ist als Ringelektrode ausgebildet und grenzt unmittelbar an eine zweite Kontaktschicht, welche die der ersten Kontaktschicht 102 gegenüberliegende Oberfläche der optoelektronischen Vorrichtung 1200 bedeckt. Der Aufbau der optoelektronischen Vorrichtung 1200 und die Anordnung der Elektroden wird nachfolgend anhand eines Querschnitts längs einer Schnittachse A - A genauer beschrieben.

**Fig. 13** zeigt einen Querschnitt durch die dritte optoelektronischen Vorrichtung nach **Fig. 12** längs einer Schnittachse A - A. Dieser Querschnitt zeigt, dass sich die dritte optoelektronische Vorrichtung 1300 von der ersten und der zweiten optoelektronischen Vorrichtung in der Anordnung und der Geometrie der Elektroden unterscheidet. Die dritte optoelektronische Vorrichtung 1300 weist ein Substrat 200 auf, auf dem einer zweite Kontaktschicht 202 aufgebracht ist. Die zweite Kontaktschicht 202 wird von der zweiten Elektrode 110 ringförmig umschlossen. Die zweite Elektrode 110 ist an den zweiten Anschluss 108 gekoppelt. Auf der zweiten Kontaktschicht 202 ist eine erste Ladungstransportschicht 204 aufgebracht. Zwischen der ersten Ladungstransportschicht 204 und einer zweiten Ladungstransportschicht 210 ist eine Funktionsschicht 208 angeordnet. Auf der zweiten Ladungstransportschicht 210 ist die erste Kontaktschicht 102 angeordnet. Die erste Kontaktschicht 102 weist einen zentralen Bereich auf, der in einer Umgebung um eine vertikale Symmetrieachse B - B eine konstante Dicke aufweist. Von diesem Bereich weg nimmt die Schichtdicke der ersten Kontaktschicht hin zu den Außenseiten und damit hin zu der Nähe der Ringelektrode ab, d.h. hin zu der zweiten Elektrode 110. In dieser Anordnung ist der laterale Verlauf der Leitfähigkeit einem radialen Verlauf gleichzusetzen. Auf dem zentralen Bereich der ersten Kontaktschicht 102 kontaktiert die erste Elektrode 106 dieselbe. Außerhalb des zentralen Bereichs ist die erste Elektrode 106 durch eine Passivierungsschicht 1300 von der ersten Kontaktschicht 102 elektrisch isoliert.

Auf der ersten Kontaktschicht 102 und auf der Elektrode 106 ist eine Verkapselung 1302 aufgebracht, die in der Fig. 12 nicht dargestellt wurde. Sie dient zu Schutz der Schichtenfolge und besteht beispielsweise auch aus einer Passivierungsschicht, einem Kunststoff, etc.

Um die erste Kontaktschicht 102 auf den übrigen Schichtstapel aufzubringen, können unterschiedliche Herstellverfahren angewendet werden. Denkbar ist beispielsweise eine Art "*spin-on*"-Verfahren, bei dem das Material der ersten Kontaktschicht 102 durch eine Blend zentral auf einen sich drehenden Schichtstapel aufgebracht wird. Ebenso ist es denkbar, dass eine Quelle das Material derart über eine Blende oder ein System konzentrischer Blenden auf eine Schichtstapel emittiert, dass das Material mit einer glockenförmige Rate auf die Oberfläche des Schichtstapels trifft. Dabei kann eine Rotation des Schichtstapels während des Bedampfens zu einer gleichmäßigen rotationssymmetrischen Ausgestaltung der ersten Kontaktschicht 102 beitragen. Ebenso ist es denkbar, beispielsweise eine rotierende Materialquelle oder ein rotierendes Blendensystem vorzusehen.

### LITERATUR

In diesem Dokument sind die folgenden Veröffentlichungen zitiert:
[1] Neyts, K. et al.: "Inhomogeneous Luminance in Organic Light Emitting Diodes Related to Electrode Resistivity": Journal of Applied Physics, Bd. 100, S. 114513 ff., American Inst. Of Physics, New York: 2006.

**BEZUGSZEICHENLISTE**

| | |
|---|---|
| Erste optoelektronische Vorrichtung | 100 |
| Erste Kontaktschicht | 102 |
| Erster Anschluss | 104 |
| Erste Elektrode | 106 |
| Zweiter Anschluss | 108 |
| Zweite Elektrode | 110 |
| Substrat | 200 |
| Zweite Kontaktschicht | 202 |
| Erste Ladungstransportschicht | 204 |
| Erste elektrische Zuleitung | 206 |
| Funktionsschicht | 208 |
| Zweite Ladungstransportschicht | 210 |
| Zweite elektrische Zuleitung | 212 |
| Erste Widerstand | 300 |
| Zweiter Widerstand | 302 |
| Dritter Widerstand | 304 |
| Vierter Widerstand | 306 |
| Fünfter Widerstand | 308 |
| Sechster Widerstand | 310 |
| Siebter Widerstand | 312 |
| Erste Diode | 314 |
| Achter Widerstand | 316 |
| Erster Knoten | 318 |
| Neunter Widerstand | 320 |
| Zweite Diode | 322 |
| Zehnter Widerstand | 324 |
| Zweiter Knoten | 326 |
| Dritter Knoten | 327 |
| Elfter Widerstand | 328 |
| Dritte Diode | 330 |
| Zwölfter Widerstand | 332 |
| Vierter Knoten | 334 |
| Erste elektrische Leitfähigkeit | 400 |
| Erste Kontaktschicht | 500 |
| Dotierprofil | 600 |
| Zweite elektrische Leitfähigkeit | 900 |
| Zweite optoelektronische Vorrichtung | 1000 |
| Dritte optoelektronische Vorrichtung | 1200 |
| Passivierung | 1300 |
| Verkapselung | 1302 |

## Patentansprüche

1. Optoelektronische Vorrichtung umfassend:
- eine erste elektrische Zuleitung (206), die an einen zweiten elektrischen Anschluss (108) gekoppelt ist,
- eine zweite elektrische Zuleitung (212), die an einen ersten elektrischen Anschluss (104) gekoppelt ist, und
- eine zwischen der ersten elektrischen Zuleitung (206) und der zweiten elektrischen Zuleitung (212) angeordnete Funktionsschicht (208) zur Emission von Strahlung, wobei die zweite elektrische Zuleitung (212) eine laterale erste elektrische Leitfähigkeit aufweist, die über eine Erstreckung der zweiten elektrischen Zuleitung (212) weg vom ersten elektrischen Anschluss (104) monoton abnimmt, **dadurch gekennzeichnet, dass** die erste elektrische Zuleitung (206) eine zweite elektrische Leitfähigkeit aufweist, die über eine Erstreckung der ersten elektrischen Zuleitung (206) weg von dem zweiten elektrischen Anschluss (108) monoton abnimmt.

2. Optoelektronische Vorrichtung gemäß Patentanspruch 1, wobei die Funktionsschicht (208) eine organische Emitterschicht umfasst.

3. Optoelektronische Vorrichtung gemäß einem der vorangehenden Patentansprüchen,
wobei die zweite elektrische Zuleitung (212) eine Kontaktschicht (210) umfasst.

4. Optoelektronische Vorrichtung gemäß Patentanspruch 3,
wobei die Kontaktschicht (210) eine konstante elektrische Flächenleitfähigkeit aufweist und sich eine Dicke der Kontaktschicht (210) über die Ersteckung der Kontaktschicht (210) weg vom ersten elektrischen Anschluss (104) monoton verändert.

5. Optoelektronische Vorrichtung gemäß einem der Patentansprüche 3 oder 4,
wobei die zweite elektrische Zuleitung (212) eine Ladungstransportschicht (210) umfasst.

6. Optoelektronische Vorrichtung gemäß Patentanspruch 5,
wobei die Ladungstransportschicht (210) ein dotiertes organisches Halbleitermaterial umfasst.

7. Optoelektronische Vorrichtung gemäß Patentanspruch 6,
wobei sich eine Dotierkonzentration des dotierten organischen Halbleitermaterials weg von dem ersten elektrischen Anschluss (104) monoton verändert.

8. Optoelektronische Vorrichtung gemäß einem der vorangehenden Patentansprüche,
wobei sich die erste elektrische Leitfähigkeit weg von dem ersten elektrischen Anschluss (104) streng monoton verändert.

9. Optoelektronische Vorrichtung gemäß einem der vorangehenden Patentansprüche,
wobei die zweite elektrische Zuleitung (212) eine Kathode bildet und die erste elektrische Leitfähigkeit einer Elektronenleitfähigkeit entspricht.

10. Optoelektronische Vorrichtung gemäß einem der vorangehenden Patentansprüche, wobei die erste elektrische Zuleitung (206) eine Anode bildet und die zweite elektrische Leitfähigkeit einer Lochleitfähigkeit entspricht.

## Claims

1. Optoelectronic device comprising:
- a first electrical feed line (206), which is coupled to a second electrical terminal (108),
- a second electrical feed line (212), which is coupled to a first electrical terminal (104), and
- a functional layer (208) for emitting radiation, said functional layer being arranged between the first electrical feed line (206) and the second electrical feed line (212),
wherein the second electrical feed line (212) has a lateral first electrical conductivity that decreases monotonically over an extent of the second electrical feed line (212) away from the first electrical terminal (104), **characterized in that** the first electrical feed line (206) has a second electrical conductivity that decreases monotonically over an extent of the first electrical feed line (206) away from the second electrical terminal (108).

2. Optoelectronic device according to Patent Claim 1,
wherein the functional layer (208) comprises an organic emitter layer.

3. Optoelectronic device according to either of the preceding patent claims,
wherein the second electrical feed line (212) comprises a contact layer (210).

4. Optoelectronic device according to Patent Claim 3,
wherein the contact layer (210) has a constant electrical surface conductivity and a thickness of the contact layer (210) changes monotonically over the extent of the contact layer (210) away from the first electrical terminal (104).

5. Optoelectronic device according to either of Patent Claims 3 and 4,
wherein the second electrical feed line (212) comprises a charge transport layer (210).

6. Optoelectronic device according to Patent Claim 5,
wherein the charge transport layer (210) comprises a doped organic semiconductor material.

7. Optoelectronic device according to Patent Claim 6,
wherein a doping concentration of the doped organic semiconductor material changes monotonically away from the first electrical terminal (104).

8. Optoelectronic device according to any of the preceding patent claims,
wherein the first electrical conductivity changes strictly monotonically away from the first electrical terminal (104).

9. Optoelectronic device according to any of the preceding patent claims,
wherein the second electrical feed line (212) forms a cathode and the first electrical conductivity corresponds to an electron conductivity.

10. Optoelectronic device according to any of the preceding patent claims,
wherein the first electrical feed line (206) forms an anode and the second electrical conductivity corresponds to a hole conductivity.

## Revendications

1. Dispositif optoélectronique comprenant :
- un premier câble d'alimentation électrique (206) qui est couplé à une deuxième borne électrique (108),
- un deuxième câble d'alimentation électrique (212) qui est couplé à une première borne électrique (104), et
- une couche de fonctionnement (208) disposée entre le premier câble d'alimentation électrique (206) et le deuxième câble d'alimentation électrique (212) en vue de l'émission d'un rayonnement,
dans lequel le deuxième câble d'alimentation électrique (212) présente une première conductivité électrique latérale qui diminue de manière monotone via une avancée du deuxième câble d'alimentation électrique (212) à distance de la première borne électrique (104), **caractérisé en ce que** le premier câble d'alimentation électrique (206) présente une deuxième conductivité électrique qui diminue de manière monotone via une avancée du premier câble d'alimentation électrique (206) à distance de la deuxième borne électrique (108).

2. Dispositif optoélectronique selon la revendication 1, dans lequel la couche de fonctionnement (208) comprend une couche émettrice organique.

3. Dispositif optoélectronique selon l'une des revendications précédentes, dans lequel le deuxième câble d'alimentation électrique (212) comprend une couche de contact (210).

4. Dispositif optoélectronique selon la revendication 3, dans lequel la couche de contact (210) présente une conductivité de surface électrique constante et une épaisseur de la couche de contact (210) se modifie de manière monotone via l'avancée de la couche de contact (210) à distance de la première borne électrique (104).

5. Dispositif optoélectronique selon l'une des revendications 3 ou 4, dans lequel le deuxième câble d'alimentation électrique (212) comprend une couche de transport de charge (210).

6. Dispositif optoélectronique selon la revendication 5, dans lequel la couche de transport de charge (210) comprend un matériau semi-conducteur organique dopé.

7. Dispositif optoélectronique selon la revendication 6, dans lequel une concentration en dopant du matériau semi-conducteur organique dopé se modifie de manière monotone à distance de la première borne électrique (104).

8. Dispositif optoélectronique selon l'une des revendications précédentes, dans lequel la première conductivité électrique se modifie de manière fortement monotone à distance de la première borne électrique (104).

9. Dispositif optoélectronique selon l'une des revendications précédentes, dans lequel le deuxième câble d'alimentation électrique (212) forme une cathode et la première conductivité électrique correspond à une conductivité d'électrons.

10. Dispositif optoélectronique selon l'une des revendications précédentes, dans lequel le premier câble d'alimentation électrique (206) forme une anode et la deuxième conductivité électrique correspond à une conductivité par trous.
